# EUROPEAN PATENT APPLICATION

(11) **EP 0 969 598 A1**
(43) Date of publication of application: **05.01.2000**
(21) Application number: 99118230.4
(22) Date of filing: 07.01.1994
(51) Int. Cl.: H03J 1/00, H04N 5/00

(54) **Tuning and memorising method compatible with a plurality of television signal receivers**

(30) Priority: 22.01.1993 IT RM930031
(62) Divisional of application: 94100137.2
(71) Applicant: EDICO S.r.l., I-00197 Roma (IT)
(72) Inventor: d'Errico, Federico, Dr., 00186 Roma (IT)
(74) Representative: Eisenführ, Speiser & Partner

(57) **Abstract**

A tuning and memorisation method of a plurality of television signal receivers is described. The main characteristic of the invention consists in that it provides an exchange of information between the receivers and that the memorisation of tuning data of a determined television broadcaster is automatically correlated in a manner to be recalled with the same reference indicator for all the receivers.

## Description

The present invention relates to a tuning and memorisation method of a plurality of television signal receivers.

It is known that usually television signal receivers, i.e. mainly televisions and video recorders, utilise various methods for the searching and tuning of the television signals to be received: for example voltage synthesis tuning and frequency synthesis tuning are known; the method is known of automatic searching of all the broadcasters (consisting in a continuous exploration of all the receivable frequency ranges) or the direct call method of a desired broadcaster; such method being initially reserved for frequency synthesis tuning systems, it has also been proposed for voltage synthesis tuning systems.

However, apart from the tuning method utilised, voltage or frequency synthesis tuning, with continuous search or direct call, the system of memorising the tuned broadcaster in a determined cell of a non volatile memory is more or less generalised, from which it can be recalled by pressing a given key or button, upon which said broadcaster has been associated, on a command device (usually a remote control unit).

The search operation, tuning and memorising has to be repeated, for every broadcaster that is normally desired to be received, i.e. normally twenty or more broadcasters, be it on the television or the video recorder.

It almost always occurs that, for the different methods of tuning and memorising utilised by various apparatus, or due to the fact that the apparatus were bought at different times, the same broadcasters are associated on the television and on the video recorder on different keys of the remote control, even if it may be the same control unit for both apparatus.

The aim of the present invention is that of indicating a tuning and memorising method of television signal receivers that eliminate, or greatly reduce, the aforementioned drawbacks of the known methods.

In view of realising such aims the present invention has as its subject a tuning and memorisation method of a plurality of television signal receivers, characterised in that it provides an exchange of information between the receivers and that the memorisation of tuning data of a determined television broadcaster is automatically correlated in a manner to be recalled with the same reference indicator for all the receivers.

The characteristics and advantages of the tuning and memorisation method according to the invention will become clear from the following description, executed with reference to the annexed drawings, that are supplied purely as an explanatory and non limiting example, wherein:
figure 1 schematically represent the connection of a television and of a video recorder according to the invention;
figure 2 schematically represents a significant part of the logic control circuit of a television signal receiver according to the invention;
figure 3 represents a simplified block diagram of a voltage synthesis television signal receiver according to the invention.

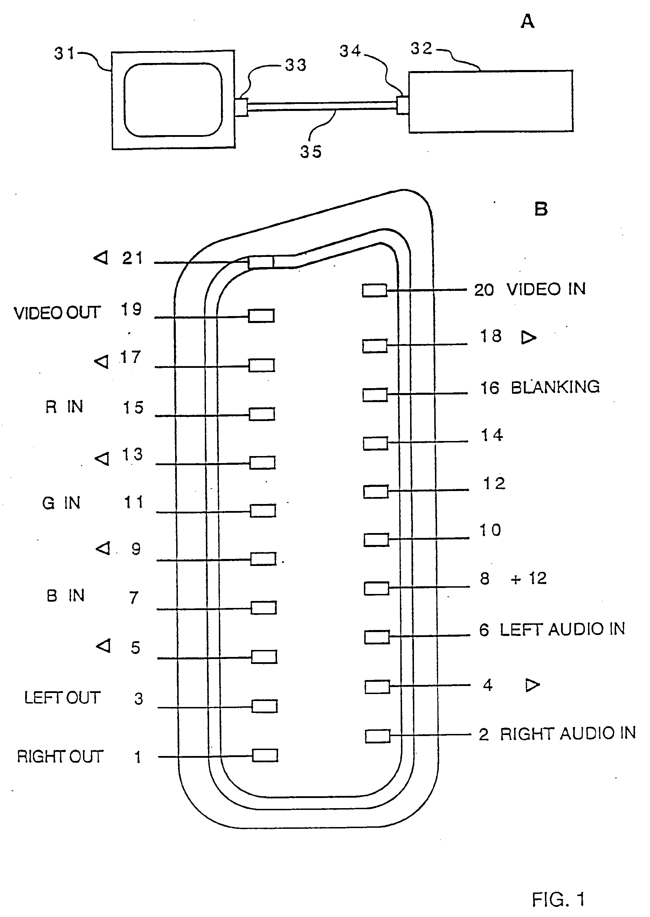

In the upper section of figure 1, distinguished with the letter A, the reference number 31 indicates a television set; with reference number 32 a video recorder is indicated; with reference number 33 a multiwire socket of the television set 31 is indicated; with reference number 34 a multiwire socket of the video recorder 32 is indicated; finally with reference number 35 a multiwire connection that connects the socket 33 of the television 31 with the socket 34 of the video recorder 32.

By way of the connection 35 the two apparatus can communicate between themselves; with the advantage that the two sockets can be of the SCART type, of which the greater part of television sets and video recorders are equipped; thus avoiding the necessity of supplementary sockets.

Supposing that the desired programs have already been memorised in the television set 31, in the relative tuning memory both the tuning data (in the case of frequency synthesis tuning the number of the channel, for example 39) and the information of the key of the remote control to which the channel is associated (for example key number 2) will be present.

We are concerned with automatically transferring such information to the tuning memory of the video recorder 32, in following an appropriate command sent by the user (for example by means of a dedicated key on the remote control unit).

It is supposed that both the television set and the video recorder are equipped with a suitable microcontroller (for example of the type SDA 2083); they are connectable between themselves and with appropriate memories (for example of the type SDA 2516) appropriately distinguished by a specific address number, by way of a so-called I²C bus, constituted by two wires plus the earth connection.

It therefore results in being easy for the microcontroller of the television to read the tuning memory of the television, to gradually transfer the data to the microcontroller of the video recorder, that provides in turn to place it in the tuning memory of the video recorder.

Naturally the tuning systems of the two apparatus must also be compatible, so as they are able to interpret in an equal way the same data.

The sockets 33 and 34 should therefore have three contact terminals, and the connection 35 should have three wires.

In the lower section of figure 1, distinguished with the letter B, a SCART is in fact represented, equipped, as can be seen with 21 pins; it can be seen how among them, and precisely those distinguished with the numbers 10,12 and 14 are normally not utilised.

It is therefore possible to utilise for example pins 10 and 12, together with an earth pin (for example pin 18) for the connection of the I²C bus.

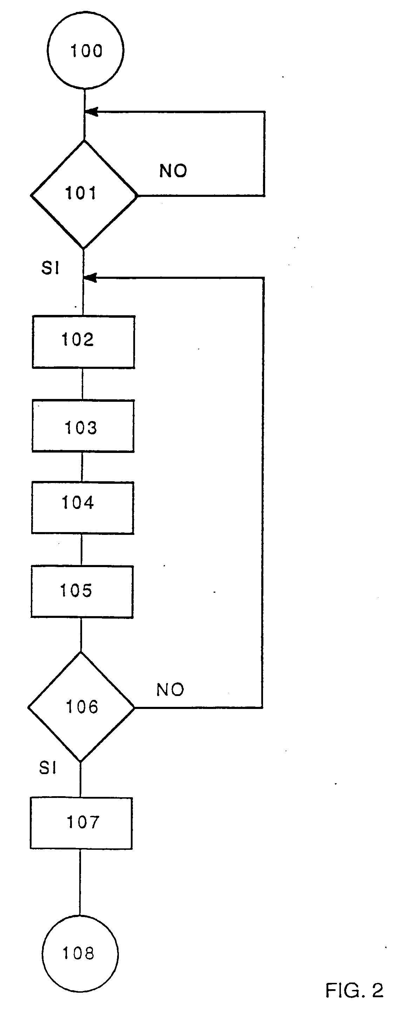

Figure 2 schematically represents a significant part of the logic control circuit of the microcontroller of the television set 31 (as mentioned the control circuit of the video recorder 32 will be the same), that will make the functioning of the operation of transferring data from the tuning memory of the television set 31 to the tuning memory of the video recorder 32 much more clearer.

Block 100 is the starting block of the operation of transferring data from the tuning memory of the television to the tuning memory of the video recorder; control passes to the successive block 101.

Block 101 is a control block; it controls whether a predetermined key (which will be called the transfer key or T key) has been pressed on a command device (remote control); in the affirmative case the control passes to block 102; in the negative the control passes back to block 101 (in all the control blocks the lower output is the YES output; the lateral output is the NO output).

Block 102 provides to:
- initialise a program number counter (N=1);
- order to the microcontroller of the television 31 to make so that the tuning memory of the television can be read;
- order to the microcontroller of the video recorder 32 to make so that the tuning memory of the video recorder can be written;
- pass the control to the successive block 103;

Block 103 provides for reading in the tuning memory of the television, at the address N, the relative data to the program n. N, i.e. the number of the channel memorised associated to the key N.

Control passes to the successive block 104.

Block 104 provides to write in the tuning memory of the video recorder, at the address N, the data relative to the program n.

N, i.e. the number of the channel memorised associated to the key N.

Control passes to the successive block 105.

Block 105 provides to increase by a unit the number N, and passes the control to the successive block 106.

Block 106 is a control block; it controls whether the number N, is greater than the number of the cells provided in the tuning memory (number of programs that can be memorised); in the affirmative case control passes to block 107; in the negative control passes back to block 102.

Block 107 provides for deactivating the memories of the television and the video recorder and passes the control to the successive block 108.

Block 108 is the final block of the operation; the control can return to either the initial block 100 or to another suitable operative block of the control circuit.

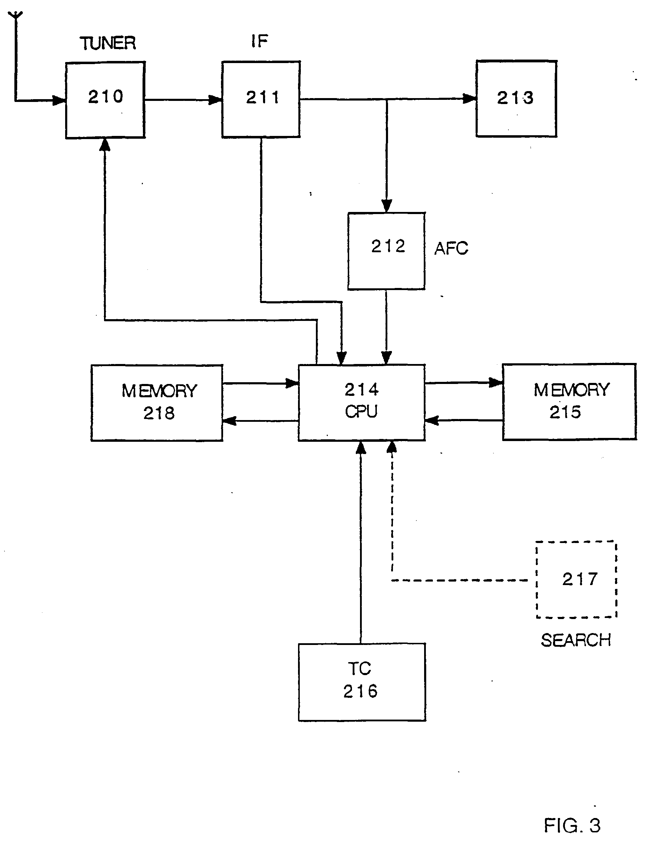

Figure 3 represents the simplified black diagram of a receiver of voltage synthesis television signals according to the invention.

If in fact, in the case of frequency synthesis receivers it is immediately understood as to how the exchange of channel numbers, associated to the number of the key (program number), it is sufficient to allow the second receiver (video recorder) to be tuned to the corresponding broadcaster, in the case of voltage synthesis receivers it is not usually quite so simple.

The receiver of figure 3 allows for the direct calling of the channel, as in a frequency synthesis receiver.

A plurality of digital codes each respectively identifying a voltage corresponding to a television channel, are memorised before the sale of the receiver in the tuning memory, to a corresponding plurality of addresses; for carrying out the direct call of the desired channel the user inputs on the command unit the channel number, that is sent to the control unit of the receiver, which reads in the tuning memory the corresponding digital code and it sends it to the tuner that provides to tune the desired channel.

A suitable automatic tuning system allows to control the drifting phenomenons, so as to always guarantee the correct tuning of the desired broadcaster.

In figure 3 reference number 210 indicates the tuner, of the conventional voltage synthesis type; with reference number 211 the assembly (being substantially of the conventional type) of intermediate frequency and signal demodulators circuit amplifiers is indicated; reference 212 indicates the automatic tuning circuit (AFC); reference number 213 indicates the assembly of remaining circuits of the television signals receiver, of the conventional type.

Still with figure 3, reference number 214 indicates a central control unit (microprocessor or microcontroller); with reference number 215 the non volatile type memory is indicated, but electrically erasable and re-writable, in which the digital codes are stored corresponding to the tuning voltages of all the television channels that can be received by the receiver of television signals in question.

Reference number 216 indicates a command organ, for sending command signals to the control unit 214; such command organ can be for example a conventional remote control transmitter, with the relative receiver.

The command signals naturally come from the command unit 214.

With reference number 217 an auxiliary command unit is indicated, that can be contained in the receiver, or, for reasons of costs, may be only available in the factory and repair stations; such auxiliary command unit serves in sending to the control unit 214 the signals necessary for carrying out the preliminary search and tuning of all the channels that can be received, and relative memorising of the digital codes relative in the memory 215.

Finally with reference number 218 a second non volatile memory is indicated, utilised for memorising the preferred channels; such memory for example can contain twenty or more cells; in every cell there will be memorised, by way of the control unit 214, in following appropriate commands inputted by the user, by way of the command unit 216, the correspondence between the channel number and the key number of the remote control unit with which said channel can be called. As is known said system of indirect calling is that normally used with voltage synthesis systems, without the possibility of direct calling; such system can be mnemonically useful (association of the channel RAI 1 with key 1, of the channel RAI 2 with key 2, and so on).

The voltage synthesis tuning method according to the invention provides that the microcontroller 214 be coupled to a D/A converter with the necessary resolution, for example 14 bits; for tuning the receiver to a determined channel the local oscillator of the tuner 210 has to oscillate to the central frequency of the channel, increased by the value of the intermediate frequency.

This is obtained by charging the D/A converter of the microcontroller with the appropriate digital tuning code and selecting the band, setting the relative band switching lines.

The tuning code converted in voltage drives the voltage controlled oscillator (VCO) of the tuner and on the same tuner act the band commutation lines.

The microcontroller in the preliminary channel search phase (and memorisation of the relative codes) increases the tuning code in steps of such to obtain in output of the voltage controlled oscillator (VCO) of the tuner frequency variations of the order of approximately 500 KHz (first velocity) for each single step; simultaneously the microcontroller tests the identification signal coming from the integrated intermediate frequency circuit 211, with the aim of detecting the presence or not of a station.

If the presence of a station is not detected, the microcontroller increases the tuning code by a further step (as such to produce a variation of the frequency of approximately 500 KHz) and carries out once again the test on the presence of the identification signal coming from the integrated intermediate frequency circuit, with the aim of detecting the presence or not of a station. These operations are carried out by the microcontroller until the information of the identification signal does not signal the presence of a station.

In the presence of a station the microcontroller modifies the increase of the tuning code for obtaining a frequency variation of approximately 200 KHz (second velocity) at every step. From this moment, at every step, the simultaneous presence of the identification signal and of the signal is tested, coming from an A/D converter, able to discriminate the level of signal coming from the automatic tuning circuit (AFC) 212.

When the microcontroller detects for the first time the beginning of the descending portion of the curve of the automatic tuning (AFC), through the reading of the A/D converter, it memorises, in the memory 215, the value of the effective tuning code in that moment and modifies the increase of the tuning code for obtaining a variation as small as possible at every step (approximately 50 KHz, third velocity), so as to have the maximum resolution.

From this moment, at every step, the simultaneous presence of the identification signal and of the signal are tested, coming from a A/D converter, with the aim of detecting the point in which the curve reaches an inferior stabilised level. At this point the microcontroller calculates out the mathematical average between the actual tuning code and that previously memorised and it memorises such average value in the memory 215, to the corresponding address of the selected channel; in this way the system will carry out a tuning of the channel closest to that being ideal.

As can be understood the pull-in range results in being very wide, and simultaneously the slope of the AFC device results in being very emphasised; in this way both a large pull-in range (assured by the digital search system) and a high tuning precision (assured by the slope of the AFC) are obtained.

In the calling phase of the channel the microcontroller has to recall from the memory 215 the previous memorised tuning code, for the D/A converter, the information relative to the band and, eventually, a code relative to the standard of transmission, in the case of multistandard receivers.

Due to the tuning drift caused by variations of temperature (be it either the environmental temperature or the temperature of the appliance itself), the tuning of the relative station may require variations of agreement voltage (and therefore of digital codes) being more or less large.

So as to overcome this the microcontroller 214 carries out corrections on the previously memorised agreement code, as will now be described; it is to be noted however that, in such phase, the corrected tuning code is not memorised.

It is understood that the maximum tuning drift has been measured as more or less 1,5 MHz. At each station change the microcontroller, after having charged the tuning data relative to the newly chosen station, tests the presence of the identification signal coming from the integrated circuit of intermediate frequency, with the aim of detecting the presence or not of a station. If the presence of a station is not detected, the microcontroller realises that the drift has taken place in a negative sense (in fact if the drift occurs in the positive sense the station always results in being present, for the characteristics of the television signal) and that it is necessary to reduce the agreement frequency respect to the one present.

The microcontroller 214 therefore reduces the tuning code by one step (equal to approximately 500 KHz in frequency) and re-executes the test on the identification signal; in the negative case the reduction and successive test are repeated up to a maximum of four times (for a total of approximately 2 Mhz), unless the presence of a station is not detected before.

In the presence of a station the microcontroller 214 modifies the variation step of the tuning code so as to obtain a frequency variation of approximately 200 KHz per step. At each step the presence of the identification signal and of the signal coming from the A/D converter are tested, an indication of the voltage level coming from the automatic tuning circuit 212.

After an analysis of the information received from the A/D converter the microcontroller 214 is able to establish whether the actual tuning code involves a positive or negative de-tuning; in the given case the exact tunings correspond to a voltage of 6 volts in output from the AFC circuit. As a consequence, in the vicinity of the exact tuning, the microcontroller 214 modifies the tuning code for obtaining a frequency variation of approximately 50 KHz in the opposite sense of the de-tuning; with successive steps the system is thus brought back to a correct tuning, eliminating the drifting effect.

In this phase a correct tuning is assumed corresponding to a signal of 6 volts in output from the automatic tuning.

Apart from this, the microcontroller 214 also provides for correction of minor entity drifting, slower in time (for instance that of eventual antenna converters).

In fact the microcontroller, even during the normal functioning of the receiver, tests the identification code, coming from the integrated circuit of intermediate frequency 211, for detecting the presence of a station; in the presence of a station the microcontroller tests the signal coming from the A/D converter, which indicates the level of voltage coming from the automatic tuning circuit 212; if the microcontroller detects a de-tuning, be it negative or positive, it provides for modifying the tuning code as a consequence, so as to obtain a variation of 50 KHz in the opposite sense of the relative de-tuning.

This constant control over time assures that the slower de-tuning become eliminated, allowing a constant perfect vision and a perfect decoding of an eventual Teletext transmission, very sensitive to perfect tuning, as is known.

On the other hand even in this control during the normal functioning the eventual correct tuning code is not memorised in the digital tuning memory.

As results from the present description, the tuning and memorising method according to the invention has substantial advantages compared with the known methods.

It is in fact immediate to transfer from the tuning memory of a first television signal receiver (television 31) the data memorised to a second television signal receiver (video recorder 32), with all of the consequent advantages.

In addition to such transfer it is possible either with synthesis tuning receivers or voltage synthesis tuning receivers, or between a receiver of the first type and one of the second type.

It is obvious that, remaining with the principles of the invention, numerous variants are possible of the characteristics of the tuning and memorising method described as an example, without for this departing from the field of novelty inherent in the inventive idea, as is clear that the apparatus used in connection with the described method in the practical use of the invention can be varied in their specific characteristics and that the components used can be substituted with technically equivalent elements.

For instance it is also convenient that the data relative to eventual fine tuning corrections recorded by the user be exchanged, based on his personal preferences.

It is also possible that, be it in the case of a television set or video recorder, an automatic tuning circuit be provided.

The described method can be used, as mentioned, also in voltage tuned appliances, however it must be a voltage tuning that allows the direct call of a television channel ; it is obvious that in this case the fine tuning correction has no sense, given that in such systems it is always present, and necessary, an automatic tuning circuit for recuperating the inevitable frequency drifts.

## Claims

1. Receiver of television signals of the voltage synthesis tuning type comprising non-volatile memory (215) in which digital codes are memorized said codes representing the tuning voltage related to all the television channels that can be received and comprising microcontroller controlled wide pull-in range digital tuning system, associated to a high tuning precision automatic tuning system (212), and with an automatic frequency drift correction control, which also provides for correcting the previously memorized tuning codes whenever necessary.

2. Receiver according to claim 1, characterised in that
- it provides an exchange of information between the receivers (31, 32) and
- the memorisation of tuning data of a determined television broadcaster is automatically correlated in a manner to be recalled with the same reference indicator for all the receivers (31, 32).

3. Receiver according to claim 1 or 2, characterised in that it provides that, for carrying out the exchange of information, the receivers (31, 32) are equipped with known peritelevision sockets of the SCART type (33, 34).

4. Receiver according to claim 1, characterised in that the exchange of information and the memorising are relative to the television channel number and to the program number or associated key (N).

5. Receiver according to claim 4, characterised in that the possibility for exchanging information and relative memorising even between a frequency synthesis receiver and a voltage synthesis receiver and vice versa.

6. Receiver according to claim 5, characterised in that it is provided that the voltage synthesis receiver comprises a non-volatile memory (215) in which the digital codes are memorised representing the tuning voltage relative to all the television channels that can be received.

7. Receiver according to claim 6, characterised in that it is provided that the voltage synthesis receiver comprises a wide range digital search system, associated to an elevated slope automatic tuning system (212).

8. Receiver according to claim 1, characterised in that it is provided that, for carrying out the exchange of information, the receivers (31, 32) be connected by way of two wires (10, 12) plus an earth connection (18).

9. Receiver according to claim 1, characterised in that it is provided that the transmission of information and the relative memorisation takes place on pressing a key or button (T) on a command device.

10. Receiver according to claim 1, characterised in that said plurality of television signal receivers comprise at least one television set (31) and one video recorder (32).
